# EUROPEAN PATENT SPECIFICATION

(11) **EP 1 845 532 B1**
(45) Date of publication and mention of the grant of the patent: **01.04.2009**
(21) Application number: 06112526.6
(22) Date of filing: 12.04.2006
(51) Int. Cl.: G11C 16/24, G11C 7/12, G11C 8/10

(54) **A column decoding system for semiconductor memory devices implemented with low voltage transistors**
Spaltendekodierungssystem für mit Niederspannungstransistoren implementierte Halbleiterspeichervorrichtungen
Un système de décodage de colonne des dispositifs de mémoire semi-conducteurs appliqués avec des transistors de basse tension

(43) Date of publication of application: 17.10.2007
(73) Proprietor: STMicroelectronics S.r.l., 20041 Agrate Brianza (Milano) (IT)
(72) Inventor: Campardo, Giovanni, 24128 Bergamo (BG) (IT); Micheloni, Rino, 22078 Turate (CO) (IT)
(74) Representative: W.P. Thompson & Co.

(56) References cited:
- EP-A- 0 314 180
- US-A- 5 650 961
- US-A1- 2004 233 703

## Description

The present invention relates to the field of the non-volatile memory devices, and more particularly, it relates to the decoding of corresponding columns.

Reference is hereby directed to United States patent 5650961 (Himeno et al) which was cited as closest prior art and overcome during prosecution of the present application. It describes a circuit for measuring cell characteristics in a NAND type EEPROM. The circuit comprises a cell array having a matrix array of NAND strings each comprising a plurality of series-connected cell transistors. In use, a selected gate line is connected to the gates of first selected gates in each NAND string within a given block, and a word line is connected to the control gates of cell transistors in each row. A first external terminal is connected to a selected bit line, and a second external terminal is connected to each word line in a plurality of blocks.

Memory devices are commonly used to store information (either temporarily or permanently) in a number of applications; particularly, in a non-volatile memory device the information is preserved even when a power supply is off. Typically, the memory device includes a matrix of memory cells that are arranged in a plurality of rows (connected to corresponding word lines) and in a plurality of columns (connected to corresponding bit lines).

For example, flash memory devices are a particular type of non-volatile memory devices, in which each memory cell is formed by a floating gate MOS transistor. Each memory cell has a threshold voltage (which depends on the electric charge stored in the corresponding floating gate), which can be programmed to different levels representing corresponding logical values.

In order to retrieve and/or store information, the memory device includes a decoding system that is adapted to decode an address code identifying a group of memory cells. In particular, the decoding system drives a row selector for selecting a corresponding word line and a column selector for selecting a corresponding set of bit lines.

Both the row selector and the column selectors must be able to apply operative voltages of high value to the selected memory cells (during program and erase operations). These voltages (for example, ranging from -9 Volts to 9 Volts) are higher than a supply voltage of the memory device, such as 3 Volts, in absolute value. For example, in single supply voltage memory devices, the high voltages are generated inside the memory device from the supply voltage, by means of suitable circuits (such as, charge pumps).

Considering in particular the column selector, a typical situation is the biasing of the selected bit lines associated with the memory cells to be programmed; in this case, the selected bit lines must be biased to a program enabling voltage of about 5 Volts.

Therefore, only the standard circuitry of the memory device (e.g., the logic circuitry) can be implemented with low voltage transistors; the low voltage transistors are designed in such a way to be able to sustain (across their terminals) voltage differences that are up-limited (in absolute value) by the supply voltage. Indeed, the low voltages that are experienced by those transistors allow their correct functioning (without causing breaking thereof) in any condition. For example, low voltage MOS transistors are designed in such a way to avoid the occurrence of gate oxide breaking or undesired junctions breakdown when low voltage differences are applied to their terminals (for example, between the gate and source terminals).

Conversely, the column selector (and the row selector as well) needs to be implemented with high voltage transistors; the high voltage transistors are instead designed in such a way to be able to sustain (across their terminals) voltage differences higher than the supply voltage. This ensures their correct functioning (without any breaking thereof) even when they are subjected to the above mentioned high voltages (exceeding the supply voltage). For example, high voltage MOS transistors are designed in such a way to avoid the occurrence of gate oxide breaking or undesired junctions breakdown even when high voltages are applied to their terminals.

The high voltage transistors must have a gate oxide layer thicker than that used for the low voltage transistors. Indeed, the thicker the gate oxide layer the higher the voltage sustained at their terminals without undesired breaking is. Since the high voltage transistors occupy more silicon area compared to the low voltage transistors, the column decoder wastes a significant area of a chip wherein the memory device is integrated.

Moreover, the use of both low voltage and high voltage transistors increases the number of processing steps and masks (for example, for differentiating the oxide thickness of the high and low voltage transistors); this has a detrimental impact on the manufacturing process of the memory device.

In principle, the present invention is based on the idea of selecting the columns with components that work at reduced voltages.

Particularly, the present invention provides a solution as set out in the independent claims. Advantageous embodiments of the invention are described in the dependent claims.

In an embodiment of the present invention, the paths of each packet are organized in a tree; in this case, the lowest transistors in the tree are of a type of conductivity different from the one of the other transistors.

Preferably, in each non-selected path the lowest transistor is biased to the open condition; the other transistors are biased to the close condition when corresponding to a transistor in the selected path, while they are biased to the drop condition otherwise.

Preferably, the lowest transistors are PMOS transistors and the other ones are NMOS transistors.

A specific biasing scheme of those transistors is also proposed.

As a further enhancement, each transistor is a low voltage transistor.

Topically, the biasing voltage applied to the selected bit line (when a corresponding memory cell has to be programmed) is a program enabling voltage.

Otherwise, when the same memory cell has not to be programmed, the biasing voltage is lower than a control voltage applied to the lowest transistor minus its threshold voltage.

Another aspect of the present invention provides a non-volatile memory device including said column decoding system.

A further aspect of the present invention provides a corresponding method.

The characterizing features of the present invention are set forth in the appended claims. The invention itself, however, as well as further features and the advantages thereof will be best understood by reference to the following detailed description, given purely by way of a non-restrictive indication, to be read in conjunction with the accompanying drawings, wherein:
Figure 1 shows a schematic block diagram of a memory device wherein the solution according to an embodiment of the present invention is applicable;
Figure 2 illustrates a generic section of a column selector included in the memory device of Figure 1 according to a decoding structure known in the art;
Figure 3 illustrates a generic section of the column selector according to an embodiment of the present invention;
Figure 4 shows the biasing voltages applied to the section of the column selector of Figure 3 during a program operation of the memory device according to an embodiment of the present invention;
Figure 5 shows the biasing voltages applied to the section of the column selector of Figure 3 during a read operation of the memory device according to an embodiment of the present invention; and
Figure 6 shows the biasing voltages applied to the section of the column selector of Figure 3 during a read operation of the memory device according to an alternative embodiment of the present invention.

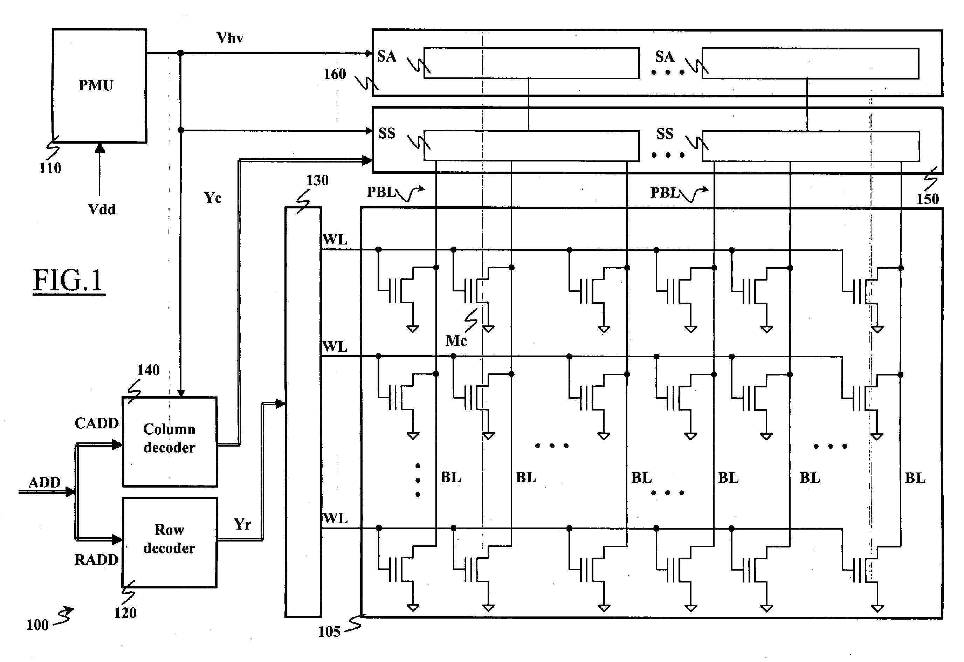

With reference to the drawings, in Figure 1 a non-volatile memory device 100, particularly a flash E²PROM, is illustrated. The memory device 100 includes a matrix 105 of memory cells Mc; typically, each memory cell Mc consists of a floating gate NMOS transistor. In an erased condition, the memory cell Mc has a low threshold voltage (conventionally associated with a logic value"1"). The memory cell Mc is programmed by injecting electric charges into its floating gate; in the programmed condition, the memory cell Mc has a high threshold voltage (conventionally associated with a logic value "0"). Therefore, when a selected memory cell Mc is biased for reading, the memory cell Mc is conductive if erased or non-conductive if programmed

The memory cells Mc are arranged in rows and columns. The memory device 100 includes a bit line for each column of the matrix 105, and a word line for each row of the matrix. The memory device 100 has a so-called NOR architecture, in which the memory cells Mc of a same column are all connected in parallel. Particularly, the memory cells Mc of each column have the drain terminals connected to a respective bit line BL, while the memory cells Mc of each row have the gate terminals connected to a respective word line WL. The source terminal of every memory cell Mc receives a reference voltage GND (or ground voltage). All the memory cells Mc must be erased at the same time. Conversely, the memory device 100 simultaneously reads/programs a word (for example, of 16 bits). The bits of each word are stored in memory cells Mc associated with a single word line WL; the bit lines BL are grouped in 16 packets PBL, each one for a bit of the word.

The memory device 100 further includes a Power Management Unit (PMU) 110. The PMU 110 provides different operative voltages Vhv that are used for performing the conventional operations (such as read, program, erase and verify) on the memory device 100. The PMU 110 generates the operative voltages Vhv from a supply voltage Vdd (such as 3 Volts) that is received from the outside; the operative voltages Vhv may be higher in absolute value than the supply voltage Vdd, for example, ranging from -9 Volts to 9 Volts. For this purpose, the PMU 110 includes a circuitry (*e.g*., charge pumps) adapted to generate the operative voltages Vhv from the supply voltage Vdd. Preferably, those charge pumps are implemented by means of low voltage transistors only, as described in Patent Application No.EP05111284.5 filed on the 25 November 2005.

Moreover, the memory device 100 receives an address code ADD for accessing a selected page of memory cells Mc storing a word. The address code ADD consists of a logical signal formed by a set of bits (such as 8-32).

The selection of the desired word line WL is carried out by means of a row decoding system including a row decoder 120 and a row selector 130. The row decoder 120 receives a portion of the address code ADD, namely, a row address RADD, and accordingly generates a plurality of row-selection signals (denoted as a whole with Yr). Preferably, the row decoder 120 is implemented with low voltage transistors only; for this purpose, it may include level shifters as described in the co-pending Patent Application No.EP06111337 filed on 17 March 2006. The row selection signals Yr are provided to the row selector 130, which enables a single word line WL. Particularly, the row selector 130 biases the selected word line WL to one of the operative voltages Vhv (according to the operation to be performed on the memory device 100), while the other word lines WL are driven to the ground voltage GND.

The selection of the desired bit lines BL is instead carried out by means of a column decoding system including a column decoder 140 and a column selector 150. The column decoder 140 receives another portion of the address code ADD, namely, a column address CADD, and accordingly generates a plurality of column-selection signals (denoted as a whole with Yc). Preferably, the column decoder 140 is implemented with low voltage transistors only; for this purpose, it may include voltage switches as described in the co-pending Patent Application No.EP06111477.3 filed on 21 March 2006. The column-selection signals Yc are provided to the column selector 150, which enables one bit line BL per packet PBL. The column selector 150 has a modular structure, comprising a sub-selector SS for each packet PBL; all the sub-selectors SS receive the same column-selection signals Yc. When necessary, each sub-selector SS connects the selected bit line BL of its packet PBL to a Read/Program (R/P) circuitry 160; the other bit lines BL are instead kept insulated from the R/P circuitry 160. The R/P circuitry 160 has a modular structure too, comprising a sub-block SA for each sub-selector SS. Each sub-block SA includes all the components (*e.g*., sense amplifiers, comparators, reference current/voltage generators, pulse generators, program load circuits and the like), which are normally required for programming the desired logic values into the selected memory cells Mc and for reading the logic values currently stored therein.

During a program operation, the selected memory cells Mc that need to be programmed (*i.e*., those memory cells Mc that have to take the logic level "0") must receive a program enabling voltage PEN (for example, 5 Volts) at their drain terminals. For this purpose, each sub-block SA provides the program enabling voltage PEN to the corresponding sub-selector SS; the sub-selector SS in turn applies the program enabling voltage PEN to the selected bit line BL. Conversely, the other selected memory cells Mc already programmed are not affected by the operation.

During a read operation, the selected memory cells Mc must receive a read enabling voltage REN (for example, 1 Volt) at their drain terminals. For this purpose, each sub-block SA provides the read enabling voltage REN to the corresponding sub-selector SS; the sub-selector SS in turn applies the read enabling voltage REN to the selected bit line BL.

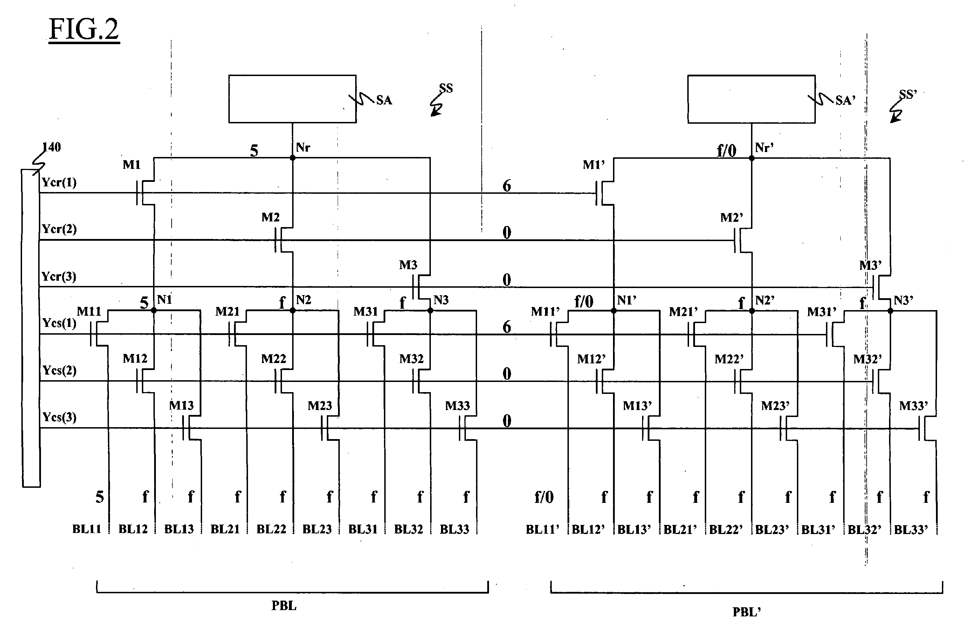

Figure 2 illustrates a more detailed view of a generic pair of adjacent sub-selectors according to an exemplary decoding structure known in the art. The two sub-selectors have the same circuital structure, and their elements will be discriminated with the addition of an apex for one of them (*i.e*., SS and SS').

Considering in particular the sub-selector SS (similar considerations apply to the sub-selector SS'), it includes a tree of selection nMOS transistors. For the sake of simplicity, the tree has two levels and it is used to select 9 bit lines; however, it will be apparent that in a real application far more levels and/or bit lines will be used.

The tree includes a root node Nr, which is directly connected to the corresponding sub-block SA. The first level of the tree consists of three legs, branching from the root node Nr. Each leg couples the root node Nr with a sub-node Ni (i=1, 2, 3), by means of a corresponding selection transistor Mi. Particularly, each selection transistor Mi has an upper conduction terminal (source/drain) connected to the root node Nr and a lower conduction terminal connected to the sub-node Ni. The control terminals of the selection transistors Mi receive respective column-selection signals (denoted with Ycr(i)) from the column decoder 140.

The second level of the tree consists of a set formed by three legs branching from each sub-node Ni (*i.e.,* 3x3=9 legs). Each set of legs couples the node Ni with three bit lines (denoted with BLij, j=1 to 3) by means of a corresponding selection transistor Mij. Particularly, each selection transistor Mij has an upper conduction terminal connected to the sub-node Ni and a lower conduction terminal connected to the bit line BLij. The control terminals of the corresponding selection transistors Mij in all the three sets of legs (*i.e.,* the j-th selection transistors Mij) receive a same selection signal (denoted with Ycs(j)) from the column decoder 140.

During any read/program operation, when necessary, the sub-block SA biases the root node Nr to the desired operative voltage Vhv to be applied to the selected bit line (any selected elements will be discriminated hereinafter by underlying their references, *i.e.,* BLij). The selection signals Ycr(i), Ycs(j) establish a conductive path between the root node Nr and the selected bit line BLij, so as to apply the operative voltage Vhv thereto. For this purpose, the selection signals Ycr(i), Ycs(j) are brought to a voltage equal to or higher than the operative voltage Vhv plus the threshold voltage of the selection transistors Mi, Mij (such as 1Volt). In this way, it is assured that the selection transistors Mi, Mij along the path from the root node Nr to the selected bit line BLij are turned on, acting as pass transistors.

The remaining selection signals Ycr(i), Ycs(j) are instead brought to the ground voltage GND. In this way, it is assured that all the selection transistors Mij receiving said voltage are always turned off since their lower conduction terminals cannot fall to a negative voltage (since each bit line BLij is coupled to a terminal providing the ground voltage through the corresponding memory cells). Consequently, the corresponding paths (from the root node Nr to the remaining bit lines BLij) include at least one selection transistor Mij that is off.

For example, during a program operation (as shown in the Figure), if the selected memory cell associated with the selected bit line BLij must be brought to the logic value "0", the sub-block SA biases the root node Nr to the program enabling voltage PEN (5 Volts); the sub-selector SS provides said program enabling voltage PEN to the selected bit line BLij. At the same time, if the other selected memory cell associated with the selected bit line BLij' must remain at the logic value "1", the sub-block SA' keeps floating the root node Nr' of the sub-selector SS' (denoted with "f" in the Figure); in this way, the selected bit line BLĳ' is kept floating as well, so as not to affect the condition of the corresponding selected memory cell. Alternatively, the sub-block SA' biases the root node Nr' of the sub-selector SS' to the ground voltage GND, so as the latter voltage is provided to the selected bit line BLij' (even with a such voltage, the condition of the corresponding selected memory cell is not affected).

Conversely, during a read operation, the sub-blocks SA and SA' bias the root nodes Nr and Nr' to the read enabling voltage REN (1 Volt); the sub-selectors SS and SS' provide said read enabling voltage REN to the selected bit lines BLij and BLij'.

The solution previously described allows reducing the number of selection signals required to address the selected bit lines BLij (as compared to the case wherein each bit line is selected by a corresponding selection signal). In any case, the selection transistors Mi, Mij may be subjected to driving voltages (between their control terminals and conduction terminals) that are higher in absolute value than the supply voltage Vdd. Indeed, the selection transistors Mi, Mij to be turned off receive the ground voltage GND at their control terminals and the operative voltage Vhv at their upper conduction terminals (from the sub-block SA directly or through the preceding selection transistors Mi when turned on). Consequently, the selection transistors Mi, Mij have to be high-voltage transistors. This involves constraints to the technology used to manufacture the integrated circuit in which the memory device is made, as previously discussed in the introduction of the present document.

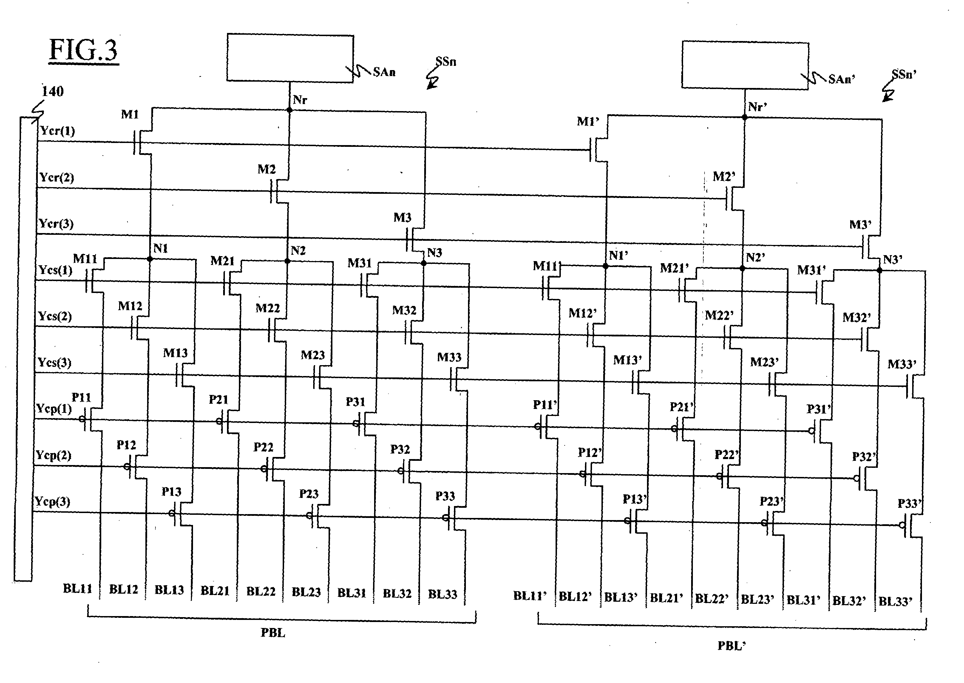

Turning now to Figure 3, the circuital structure of a generic pair of adjacent sub-selectors is illustrated, according to an embodiment of the present invention (these sub-selectors and the corresponding sub-blocks are differentiated by adding the index 'n', *i.e.,* SSn, SSn' and San, SAn', respectively). The elements corresponding to the ones shown in the Figure 2 are denoted with the same references, and their explanation is omitted for the sake of brevity.

The sub-selector SSn (similar considerations apply to the sub-selector SSn') has the same circuital structure of that described with reference to the Figure 2, with the exception that in the sub-selector SSn each leg of the lowest level (*i.e.,* the second one) includes an additional selection transistor of the opposite type of conductivity.

Particularly, each selection transistor Mij is connected to the corresponding bit line BLij through a pMOS selection transistor Pij. More in detail, the selection transistor Pij has an upper conduction terminal connected to the lower conduction terminal of the selection transistor Mij and a lower conduction terminal connected to the bit line BLij; the control terminals of the corresponding selection transistors Pij in all the three sets of legs receive a same selection signal (denoted with Ycp(j)) from the column decoder 140.

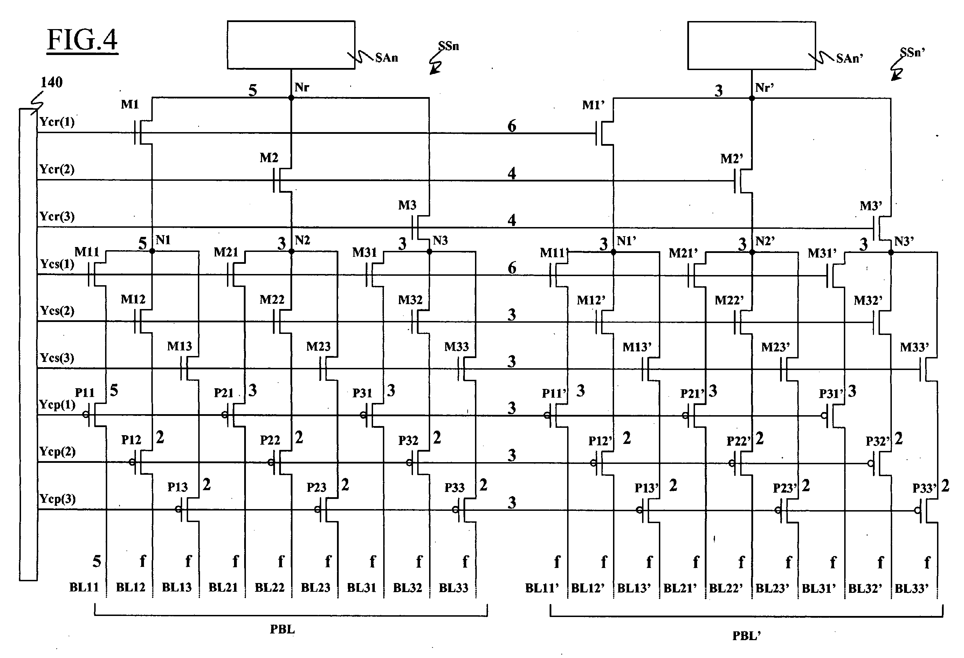

In order to describe how the sub-selectors SSn and SSn' operate during a program operation and a read operation, reference will be now made to the Figures 4, 5 and 6.

More particularly, Figure 4 illustrates a program operation. As above, if the selected memory cell associated with the selected bit line BLij must be brought to the logic value "0", the sub-block SAn biases the root node Nr to the program enabling voltage PEN (5 Volts). The selection signals Ycr(i), Ycs(j), Ycp(j) establish a conductive path between the root node Nr and the selected bit line BLij, so as to apply the program enabling voltage PEN thereto. For this purpose, the selection signals Ycr(i), Ycs(j) are again brought to a voltage equal to or higher than the program enabling voltage PEN plus the threshold voltage of the selection transistors Mi, Mij, *i.e.,* Ycr(i), Ycs(j) ≥ 5+1=6 Volts, such as Ycr(i)=Ycs(j)=6 Volts; in this way, the selection transistors Mi, Mij are turned on, acting as pass transistors. Moreover, the selection signal Ycp(j) is brought to a voltage equal to or lower than the program enabling voltage PEN minus the threshold voltage of the selection transistor Pij, *i.e.*, Ycp(j) ≤ 5-1=4 Volts, such as, Ycp(j) = 3 Volts. In this way, it is assured that the selection transistor Pij is turned on too.

In order to maintain the others (unselected) bit lines BLij floating, the remaining selection signals Ycr(i), Ycs(j), Ycp(j) are brought to different voltages, as described in the following.

Observing in greater detail the first level of the tree, the selection signals Ycr(i) are instead brought to a voltage lower than the program enabling voltage PEN plus the threshold voltage, and preferably slightly lower than the program enabling voltage PEN; however, the selection signals Ycr(i) must be equal to or higher than the ground voltage GND plus the threshold voltage. In other words, it must be 0+1=1 ≤ Ycr(i) < 5+1=6. Preferably, the selection signals Ycr(i) are not lower than the program enabling voltage PEN minus the supply voltage (*i.e.,* Ycr(i) ≥ 5-3=2 Volts); for example, the selection signals Ycr(i) are set to 4 Volts. Consequently, the voltages at the lower conduction terminals of the selection transistors Mij try to take approximately the value at the control terminals minus their threshold voltage (*i.e.*, 4-1=3 Volts). In this way, the lower conduction terminals of said selection transistors Mi act as source terminals, keeping the selection transistors Mi turned on. However, the selection transistors Mi do not act as pass transistors, but they behave instead as "voltage reducers", causing voltage drops in the corresponding legs at least equal to their threshold voltages.

As a result, while the sub-node Ni is brought to 5 Volts, the other sub-nodes Ni are brought to a lower voltage (3 Volts in the example at issue).

Moving now to the second level of the tree, the selection transistors Mij that correspond to the selection transistor Mij receive the same selection signal Ycs(j). Therefore, they have the upper conduction terminals at a voltage (3 Volts) that is lower than the voltage at their control terminals (6 Volts); consequently, they are turned on and act as pass transistors, providing the voltages of their upper conduction terminals to the upper conduction terminals of the corresponding selection transistors Pij. However, since the control terminals of the latter selection transistors Pij are biased at the same voltage (*i.e.*, Ycp(j)=3 Volts), they are turned off, and the corresponding bit lines BLij are floating.

The remaining selection signals Ycs(j) are brought to a voltage comprised between the voltage at the node Ni plus the threshold voltage and the ground voltage plus the threshold voltage (*i.e.,* 0+1=1 ≤ Ycs(j) < 3+1=4 Volts); preferably, the selection signals Ycs(j) are not lower than the voltage at the node Ni minus the supply voltage (*i.e.*, Ycs(j) ≥ 3-3 = 0 Volts), such as Ycs(j) = 3 Volts. As above, the corresponding selection transistors Mij act as voltage reducers, with their lower conduction terminals (and then the upper conduction terminals of the corresponding selection transistors Pij) that are brought to a voltage of 3-1 =2 Volts. The selection signals Ycp(j) applied to the control terminals of the selection transistors Pij is set higher than the voltages at their upper conduction terminals minus the threshold voltage (*i.e.,* Ycp(j) > 2-1 = 1 Volt); preferably, the selection signals Ycp(j) are not higher than the voltage at the upper conduction terminals of the selection transistors Pij plus the supply voltage (*i.e.,* Ycp(j) ≤ 2+3 = 5 Volts, such as Ycp(j) = 3 Volts). Therefore, said selection transistors Pij are turned off, and the corresponding bit lines BLij are floating.

It should be noted that the combined action of lowering the voltage along each non-selected path (by means of one or more selection transistors Mi, Mij acting as voltage reducers) and of having selection transistors Pij of the pMOS type at the interface with the corresponding bit lines BLij allows turning off the latter ones even when they receive the same selection signal Ycp(j) of the selection transistor Pij. This result is achieved by lowering the voltages at the upper conduction terminals of the selection transistors Pij below the voltage of the selection signals Ycp(j) plus the threshold voltage.

At the same time, let us assume that the other selected memory cell associated with the selected bit line BLij' must remain at the logic value "1". In this case, if the root node Nr' of the sub-selector SSn' was kept floating or to the ground voltage GND, as in the case of the sub-selector SS' illustrated in Figure 2, the selection transistors Mi', Mi' of the first level would be subjected to a voltage of 6 Volts between their control terminals and upper conduction terminals (and therefore capable of being sustained by high voltage transistors only).

In order to avoid this problem, the sub-block SAn' biases the root node Nr' to a voltage (denoted with PF) lower than the program enabling voltage PEN. However, this voltage is set to be not lower than the highest selection signal Ycr(i) minus the supply voltage (*i*.*e*., PF ≥ 6-3=3 Volts), but at the same time not higher than the lowest selection signal Ycp(j) plus the threshold voltage of the selection transistors Pij (*i.e.,* PF ≤ 3+1=4 Volts); for example, the root node Nr' is biased to 3 Volts. In this way, all the selection transistors Mi', Mi' of the first level are turned on, so as to convey said voltage of 3 Volts to the sub-nodes Ni', Ni'.

The selection transistors Mij', Pij' (in the non-selected paths) behave as in the sub-selector SSn, because their biasing configuration is exactly the same (so that the corresponding bit lines BLij are floating).

Regarding instead the path to the selected bit line BLij', the sub-node Ni' is at a voltage (3 Volts) lower than the one (5 Volts) of the corresponding node Ni of the sub-selector SSn. In this way, the selection transistor Mij is turned on, so that the voltage of 3 Volts at the sub-node Ni' is conveyed to the upper conduction terminal of the selection transistor Pij'. However, since the control terminal of the selection transistor Pij' is at 3 Volts, too, this transistor is turned off, and the corresponding bit line BLij' is kept insulated from the sub-block SA'.

Thanks to the biasing and circuital configuration herein proposed, all the selection transistors are subjected to driving voltages (between their control terminals and conduction terminals) that are at most equal to the supply voltage Vdd (*i.e.*, 3 Volts); consequently, all the selection transistors may be implemented using low voltage transistors (both p-channel and n-channel).

In this way, it is possible to reduce the area of the chip wherein the memory device is integrated.

Moreover, implementing the column selector (and the row selector as well) with low voltage transistors only (so as to use a single oxide thickness), reduces the number of processing steps and masks, with a beneficial impact on the manufacturing process of the memory device.

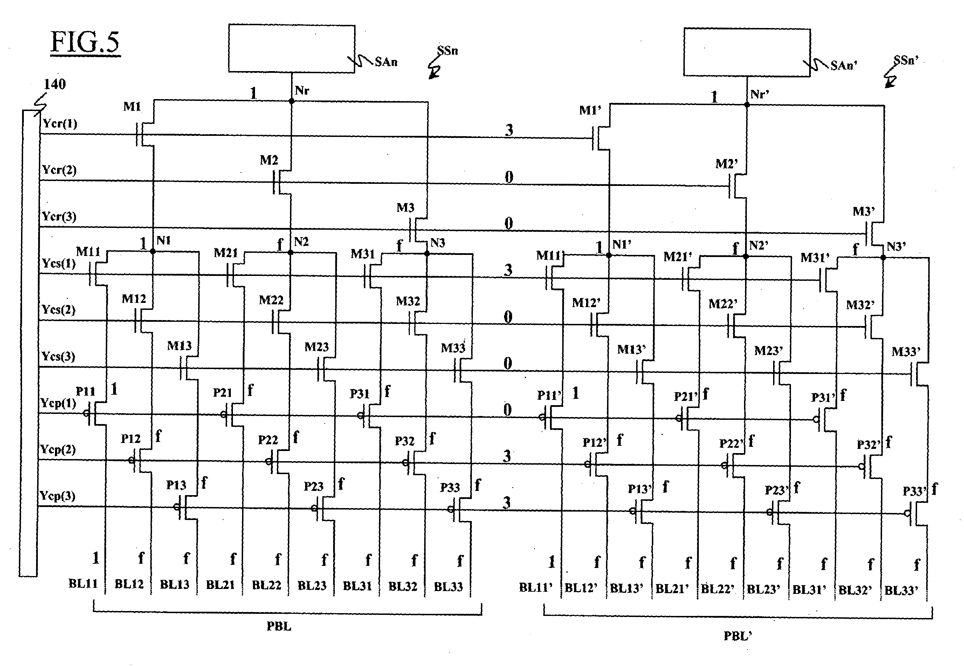

Figure 5 illustrates the biasing configuration of the sub-selectors SSn and SSn' during a read operation according to an embodiment of the present invention. More particularly, Figure 5 shows the configuration corresponding to the case in which the column decoder 140 is capable of generating non-negative selection signals Yc only.

According to this embodiment of the invention, during a read operation the sub-block SAn biases the root node Nr to the read enabling voltage REN (equal to about 1 Volt); the sub-selector SSn in turn provides the read enabling voltage REN to the bit line BLij (corresponding to the selected memory cell that has to be read), while the other bit lines BLij are kept floating.

For this purpose, a conductive path is established between the root node Nr and the selected bit line BLij: the selection signals Ycr(i) and Ycs(j) are brought to a voltage equal to or higher than the read enabling voltage REN plus the threshold voltage of the corresponding selection transistors Mi, Mij, *i.e.,* Ycr(i) = Ycs(j) ≥ 1+1=2 Volts (such as, 3 Volts); moreover, the selection signal Ycp(j) is brought to a voltage equal to or lower than the read enabling voltage REN minus the threshold voltage of the selection transistor Pij, *i.e.*, Ycp(j) ≤ 1-1=0 Volts, and then Ycp(j) =0 Volts.

In this way, the selection transistors Mi, Mij Pij are turned on, and the read enabling voltage REN is applied to the selected bit line Blij. Depending on the state of the addressed memory cell Mc, the voltage at the selected bit line BLij may persist at the value of 1 Volt (programmed memory cell) or may tend toward the ground voltage GND (not programmed memory cell).

In order to keep floating all the other (unselected) bit lines BLij, the selection signals Ycr(i) and Ycs(j) are brought, for example, to the ground voltage GND, in such a way to turn off the corresponding selection transistors Mi and Mij; at the same time, the selection signals Ycp(j) are brought to a voltage higher than the read enabling voltage REN plus the threshold voltage of the corresponding selection transistors Pij, *i.e.,* Ycp(j) > 1+1 = 2, in such a way to turn off the latter ones; preferably, the selection signals Ycp(j) are set to be not higher than the reading enabling voltage REN plus the supply voltage (*i.e.,* Ycp(j) ≤ 1+3= 4 Volts). For example, the selection signals Ycp(j) are set to 3 Volts.

It may be appreciated that, since the upper conduction terminal of the (pMOS) selection transistor Pij is at a voltage of 1 Volt and the selection signal Ycp(j) cannot be brought below the ground voltage GND (because in this embodiment the column decoder 140 is capable of generating non-negative voltages only), the dynamic range of the selection transistor Pij is scarcely sufficient for allowing the use of the latter as a pass transistor.

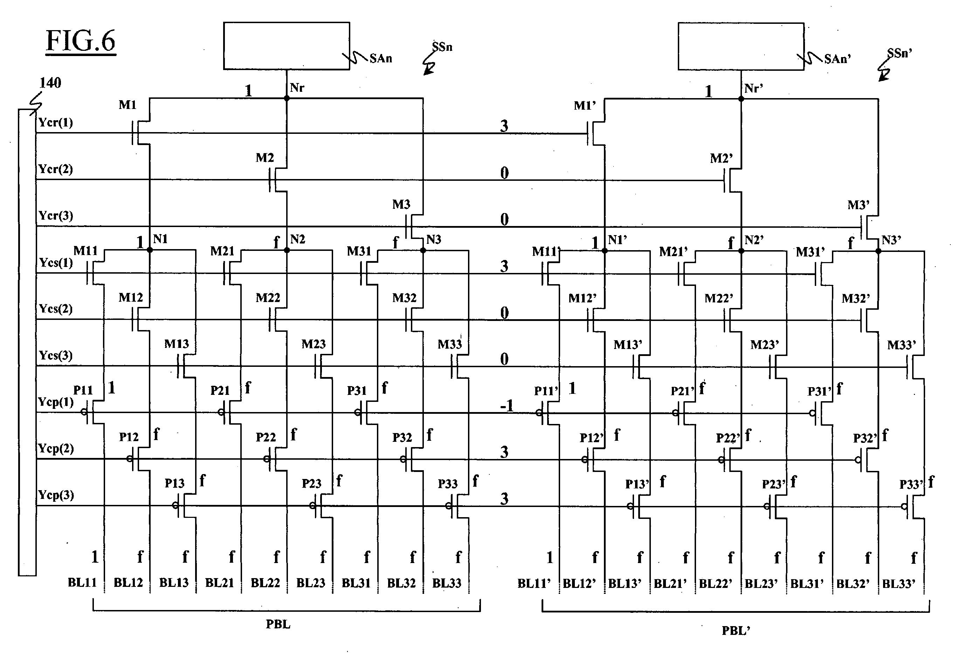

This drawback can be overcome if the column decoder 140 is capable of generating both negative and positive voltages, as in the further embodiment of the present invention illustrated in Figure 6.

In particularly, all the selection signals other than Ycp(j) take the same values as above. However, in this case, the selection signal Ycp(j) is brought to a negative voltage; preferably, the selection signal Ycp(j) is set to a voltage not lower than the read enabling voltage REN minus the supply voltage, *i.e.,* Ycp(j) ≥ 1-3 = -2 Volts, such as -1 Volt, As a result, the dynamic range of the selection transistor Pij is increased, because the voltage difference across its upper conduction terminal and its control terminal is equal to 2 Volts (*i.e.*, twice the threshold voltage).

Also in the cases illustrated in the Figures 5 and 6, all the selection transistors Mi, Mij, Pij are subjected to driving voltages (between their control terminals and conduction terminals) that are at most equal to the supply voltage Vdd. Consequently, the selection transistors Mi, Mij, Pij may be low voltage transistors.

Naturally, in order to satisfy local and specific requirements, a person skilled in the art may apply to the solution described above many modifications and alterations. Particularly, although the present invention has been described with a certain degree of particularity with reference to preferred embodiment(s) thereof, it should be understood that various omissions, substitutions and changes in the form and details as well as other embodiments are possible; moreover, it is expressly intended that specific elements and/or method steps described in connection with any disclosed embodiment of the invention may be incorporated in any other embodiment as a general matter of design choice.

For example, similar considerations apply if the memory device has a different structure or includes equivalent elements (such as, with a different word length and with different corresponding packets of bit lines).

Moreover, even if reference has been made to non-volatile memory devices of the flash type with NOR structure, the concepts of the present invention are also applicable to other memory types, such as multilevel flash memories, EEPROM or phase-change memories.

Similar considerations apply if the tree has a different number of levels and/or legs.

Of course, it should be readily apparent that each selection leg of the tree may include more than one selection transistor.

However, nothing prevents applying the same solution to a standard decoding structure (with each bit line being directly connected to the R/P circuit through a dedicated path).

Moreover, it is not excluded the presence of more transistors acting as voltage reducers in the non-selected paths.

Similar considerations apply to a dual structure (wherein the nMOS transistors and the pMOS transistors are exchanged).

Alternatively, the selection transistors may be replaced by other types of transistors (such as bipolar transistors), or by equivalent electronic devices.

Of course, the proposed circuital examples are merely illustrative, and must not be interpreted in a limitative manner.

The concepts of the present invention are also applicable to selection transistors capable of sustaining between each pair of their terminals a voltage difference (slightly) higher than the supply voltage.

The same considerations are also applicable when the column selector is used during any other operation on the selected memory cells, such as a program verify, a selective erasing and the like.

## Claims

1. A column decoding system (140, 150) for selectively biasing bit lines (BLij) of a non-volatile memory device (100), the bit lines being logically grouped into at least one packet (PBL), wherein for each packet the column decoding system includes:
a plurality of selection paths each one for applying a biasing voltage to a corresponding bit line, each path including a plurality of series-connected selection transistors (Mi, Mij, Pij) each one having a threshold voltage; and
selection means for selecting a path corresponding to a selected bit line, the selection means including means for biasing at least one transistor in each non-selected path to an open condition to have the corresponding non-selected bit line floating,
**characterized in that**
the selection means further includes means for biasing at least one other transistor in each non-selected path to a drop condition to introduce a voltage drop in the non-selected path higher than the threshold voltage of said one transistor in absolute value.

2. The column decoding system (140, 150) of claim 1, wherein for each packet (PBL) the paths are organized in a tree including a plurality of levels of nodes (Nr, Ni) descending from a root node (Nr), for receiving the biasing voltage, to a plurality of leaf nodes, each one coupled to a corresponding bit line (BLij), wherein each non-leaf node has a set of multiple selection legs depending thereon, each leg extending from the non-leaf node to a node of a lower level and including at least one of the transistors (Mi, Mij, Pij),
wherein the selection means is adapted to apply a control voltage (Ycr(i), Ycs(j), Ycp(j)) to each transistor, the corresponding transistors in the sets depending on nodes at the same level receiving the same control voltage; and
wherein in each path the lowest transistor (Pij) is of a first type of conductivity and the transistors different from the lowest transistor are of a second type of conductivity opposite to the first type.

3. The column decoding system (140, 150) of claim 2, wherein for the selected path the selection means is adapted to bias:
each transistor (Mi, Mij) different from the lowest transistor (Pij) to a closed condition to apply the biasing voltage to the lowest transistor; and
the lowest transistor to the closed condition to apply the biasing voltage to the selected bit line when the selected bit line is to be accessed, or to the open condition otherwise,
and wherein for each non-selected path the selection means is adapted to bias:
the lowest transistor to the open condition;
each transistor different from the lowest transistor corresponding to a transistor in the selected path to the closed condition; and
the remaining transistors to the drop condition.

4. The column decoding system (140, 150) of claim 2 or 3, wherein each transistor (Mi, Mij) of the first type is a PMOS transistor and each transistor (Pij) of the second type is an NMOS transistor.

5. The column decoding system (140, 150) of claim 4, wherein:
each transistor (Mi, Mij, Pij) is inserted in the corresponding leg through an upper conduction terminal and a lower conduction terminal, and receives the corresponding control voltage at a control terminal, wherein each bit line (BLij) is coupled to a terminal providing a ground voltage through a corresponding set of memory cells, and wherein:
for each NMOS transistor (Mi, Mij), the control voltage applied to the control terminal being equal to or higher than the voltage at the upper conduction terminal plus the threshold voltage to bring the NMOS transistor to the close condition;
for each PMOS transistor (Pij), the control voltage applied to the control terminal being equal to or lower than the voltage at the upper conduction terminal minus the threshold voltage to bring the transistor to the close condition;
for each PMOS transistor (Pij), the control voltage applied to the control terminal being higher than the voltage at the upper conduction terminal minus the threshold voltage to bring the transistor to the open condition; and
for each NMOS transistor (Mi, Mij), the control voltage applied to the control terminal being lower than the voltage at the upper conduction terminal plus the threshold voltage but equal to or higher than the ground voltage plus the threshold voltage to bring the transistor to the drop condition.

6. The column decoding system (140, 150) of claim 5, wherein the voltage between each pair of terminals of each transistor (Mi, Mij, Pij) is at most equal to a power supply voltage of the memory device, each transistor being a low voltage transistor suitable to sustain at most the power supply voltage between each pair of terminals thereof.

7. The column decoding system (140, 150) of any one among claims 3 to 6, wherein during a program operation the biasing voltage for each packet (PBL) which selected bit line (BLij) is to be accessed is a program enabling voltage.

8. The column decoding system (140, 150) of any one among claims 3 to 7, wherein during a program operation the biasing voltage for each packet (PBL) which selected bit line (BLij) is not to be accessed is lower than the control voltage applied to the corresponding lowest transistors plus the threshold voltage.

9. A non-volatile memory device (100) including:
a plurality of bit lines (BLij), the bit lines being grouped into at least one packet;
a column decoding system (140, 150) for selectively biasing the bit lines to a biasing voltage; and
means (SAn, SAn') for providing the biasing voltage,
**characterized in that:**
the column decoding system is the column decoding system of any one of the preceding claims.

10. A column decoding method for selectively biasing bit lines of a non-volatile memory device, the bit lines being logically grouped into at least one packet, wherein the method includes the steps of:
selecting a path corresponding to a selected bit line among a plurality of selection paths each one for applying a biasing voltage to a corresponding bit line, each path including a plurality of series-connected selection transistors each one having a threshold voltage, the step of selecting including:
biasing at least one transistor in each non-selected path to an open condition to have the corresponding non-selected bit line floating,
**characterized in that** the step of selecting further includes:
biasing at least one other transistor in each non-selected path to a drop condition to introduce a voltage drop in the non-selected path higher than the threshold voltage of said one transistor in absolute value.

## Patentansprüche

1. Spaltendekodiersystem (140, 150) zum selektiven Vorspannen von Bitleitungen (BLij) eines nichtflüchtigen Speichergerätes (100), wobei die Bitleitungen logisch zu wenigstens einem Paket (PBL) gruppiert sind, wobei für jedes Paket das Säulendekodiersystem Folgendes umfasst:
mehrere Auswahlpfade jeweils zum Anlegen einer Vorspannung an eine entsprechende Bitleitung, wobei jeder Pfad mehrere in Reihe geschaltete Auswahltransistoren (Mi, Mij, Pij) beinhaltet, die jeweils eine Schwellenspannung haben; und
Auswahlmittel zum Wählen eines Pfades, der einer gewählten Bitleitung entspricht, wobei das Auswahlmittel Mittel zum Vorspannen von wenigstens einem Transistor in jedem nicht gewählten Pfad in einen offenen Zustand beinhaltet, so dass die entsprechende nicht gewählte Bitleitung schwebend ist,
**dadurch gekennzeichnet, dass**
das Auswahlmittel ferner Mittel zum Vorspannen von wenigstens einem anderen Transistor in jedem nicht gewählten Pfad in einen Abfallzustand beinhaltet, um einen Spannungsabfall in dem nicht gewählten Pfad einzuführen, der höher ist als die Schwellenspannung des genannten einen Transistors in absolutem Wert.

2. Spaltendekodiersystem (140, 150) nach Anspruch 1, wobei die Pfade für jedes Paket (PBL) zu einem Baum mit mehreren Ebenen von Knoten (Nr, Ni), absteigend von einem Stammknoten (Nr) zum Empfangen der Vorspannung zu mehreren Blattknoten organisiert sind, die jeweils mit einer entsprechenden Bitleitung (BLij) gekoppelt ist, wobei jeder Nicht-Blatt-Knoten einen Satz von mehreren davon abhängigen Auswahlschenkeln hat, wobei jeder Schenkel von dem Nicht-Blatt-Knoten zu einem Knoten einer tieferen Ebene verläuft und wenigstens einen der Transistoren (Mi, Mij, Pij) beinhaltet,
wobei das Auswahlmittel die Aufgabe hat, eine Steuerspannung (Ycr(i), Ycs(j), Ycp(j)) an jeden Transistor anzulegen, wobei die entsprechenden Transistoren in den Sätzen von Knoten auf derselben Ebene abhängen, die dieselbe Steuerspannung erhalten; und
wobei in jedem Pfad der tiefste Transistor (Pij) von einem ersten Leitfähigkeitstyp ist und die Transistoren, die sich vom tiefsten Transistor unterscheiden, von einem zweiten, dem ersten Typ entgegengesetzten Leitfähigkeitstyp sind.

3. Spaltendekodiersystem (140, 150) nach Anspruch 2, wobei für den gewählten Pfad das Auswahlmittel die Aufgabe hat, wie folgt vorzuspannen:
jeden Transistor (Mi, Mij), der sich vom tiefsten Transistor (Pij) unterscheidet, in einen geschlossenen Zustand, um die Vorspannung an den tiefsten Transistor anzulegen; und
den tiefsten Transistor in den geschlossenen Zustand, um die Vorspannung an die gewählte Bitleitung anzulegen, wenn auf die gewählte Bitleitung zugegriffen werden soll, ansonsten in den offenen Zustand,
und wobei für jeden nicht gewählten Pfad das Auswahlmittel die Aufgabe hat, wie folgt vorzuspannen:
den tiefsten Transistor in den offenen Zustand;
jeden Transistor, der sich vom tiefsten Transistor unterscheidet, der einem Transistor in dem gewählten Pfad entspricht, in den geschlossenen Zustand; und
die übrigen Transistoren in den Abfallzustand.

4. Spaltendekodiersystem (140, 150) nach Anspruch 2 oder 3, wobei jeder Transistor (Mi, Mij) des ersten Typs ein PMOS-Transistor und jeder Transistor (Pij) des zweiten Typs ein NMOS-Transistor ist.

5. Spaltendekodiersystem (140, 150) nach Anspruch 4, wobei:
jeder Transistor (Mi, Mij, Pij) in den entsprechenden Schenkel durch einen oberen Leitungsanschluss und einen unteren Leitungsanschluss eingefügt wird und die entsprechende Steuerspannung an einem Steueranschluss erhält, wobei jede Bitleitung (BLij) mit einem Anschluss gekoppelt ist, der eine Massespannung durch einen entsprechenden Satz von Speicherzellen anlegt, und wobei:
für jeden NMOS-Transistor (Mi, Mij) die an den Steueranschluss angelegte Steuerspannung gleich oder höher als die Spannung am oberen Leitungsanschluss plus der Schwellenspannung ist, um den NMOS-Transistor in den geschlossenen Zustand zu bringen;
für jeden PMOS-Transistor (Pij) die an den Steueranschluss angelegte Steuerspannung gleich oder niedriger ist als die Spannung am oberen Leitungsanschluss minus der Schwellenspannung, um den Transistor in den geschlossenen Zustand zu bringen;
für jeden PMOS-Transistor (Pij) die an den Steueranschluss angelegte Steuerspannung höher ist als die Spannung am oberen Leitungsanschluss minus der Schwellenspannung, um den Transistor in den offenen Zustand zu bringen; und
für jeden NMOS-Transistor (Mi, Mij) die an den Steueranschluss angelegte Steuerspannung niedriger ist als die Spannung am oberen Leitungsanschluss plus der Schwellenspannung, aber gleich oder höher als die Massespannung plus der Schwellenspannung, um den Transistor in den Abfallzustand zu bringen.

6. Spaltendekodiersystem (140, 150) nach Anspruch 5, wobei die Spannung zwischen jedem Paar Anschlüsse jedes Transistors (Mi, Mij, Pij) höchstens gleich einer Stromversorgungsspannung des Speichergerätes ist, wobei jeder Transistor ein Niederspannungstransistor ist, der geeignet ist, höchstens die Stromversorgungsspannung zwischen jedem Paar Anschlüsse davon auszuhalten.

7. Spaltendekodiersystem (140,150) nach einem der Ansprüche 3 bis 6, wobei während einer Programmoperation die Vorspannung für jedes Paket (PBL), auf dessen gewählte Bitleitung (Blij) zugegriffen werden soll, eine Programm-Enabling-Spannung ist.

8. Spaltendekodiersystem (140, 150) nach einem der Ansprüche 3 bis 7, wobei während einer Programmoperation die Vorspannung für jedes Paket (PBL), auf dessen gewählte Bitleitung nicht zugegriffen werden soll, niedriger ist als die Steuerspannung, die an die entsprechenden tiefsten Transistoren angelegt wird, plus der Schwellenspannung.

9. Nichtflüchtiges Speichergerät (100), das Folgendes beinhaltet:
mehrere Bitleitungen (BLij), wobei die Bitleitungen zu wenigstens einem Paket gruppiert werden;
ein Spaltendekodiersystem (140,150) zum selektiven Vorspannen der Bitleitungen auf eine Vorspannung; und
Mittel (SAn, SAn') zum Anlegen der Vorspannung,
**dadurch gekennzeichnet, dass** das Spaltendekodiersystem das Spaltendekodiersystem nach einem der vorherigen Ansprüche ist.

10. Spaltendekodierverfahren zum selektiven Vorspannen von Bitleitungen eines nichtflüchtigen Speichergeräts, wobei die Bitleitungen logisch zu wenigstens einem Paket gruppiert werden, wobei das Verfahren die folgenden Schritte beinhaltet:
Auswählen eines Pfades, der einer gewählten Bitleitung entspricht, aus mehreren Auswahlpfaden jeweils zum Anlegen einer Vorspannung an eine entsprechende Bitleitung, wobei jeder Pfad mehrere in Reihe geschaltete Auswahltransistoren jeweils mit einer Schwellenspannung beinhaltet, wobei der Schritt des Auswählens Folgendes beinhaltet:
Vorspannen von wenigstens einem Transistor in jedem nicht gewählten Pfad in einen offenen Zustand, so dass die entsprechende nicht gewählte Bitleitung schwebend ist,
**dadurch gekennzeichnet, dass** der Schritt des Auswählens ferner das Vorspannen von wenigstens einem anderen Transistor in jedem nicht gewählten Pfad in einen Abfallzustand beinhaltet, um einen Spannungsabfall in dem nicht gewählten Pfad einzuführen, der höher ist als die Schwellenspannung des genannten einen Transistors in absolutem Wert.

## Revendications

1. Un système de décodage de colonnes (140, 150) destiné à polariser de manière sélective des lignes de bits (BLij) d'un dispositif à mémoire non volatile (100), les lignes de bits étant groupées logiquement en au moins un paquet (PBL), où pour chaque paquet le système de décodage de colonnes comprend :
une pluralité de chemins de sélection, chacun d'eux étant destiné à appliquer une tension de polarisation à une ligne de bits correspondante, chaque chemin comprenant une pluralité de transistors de sélection reliés en série (Mi, Mij, Pij), chacun d'eux possédant une tension seuil, et
un moyen de sélection destiné à sélectionner un chemin correspondant à une ligne de bits sélectionnée, le moyen de sélection comprenant un moyen de polariser au moins un transistor dans chaque chemin non sélectionné vers une condition ouverte de façon à faire flotter la ligne de bits non sélectionnée correspondante,
**caractérisé en ce que**
le moyen de sélection comprend en outre un moyen de polariser au moins un autre transistor dans chaque chemin non sélectionné vers une condition de chute de façon à introduire une chute de tension dans le chemin non sélectionné plus élevée que la tension seuil dudit un transistor en valeur absolue.

2. Le système de décodage de colonnes (140, 150) selon la Revendication 1, où pour chaque paquet (PBL) les chemins sont organisés en une arborescence comprenant une pluralité de niveaux de noeuds (Nr, Ni) descendant d'un noeud racine (Nr), de façon à recevoir la tension de polarisation, vers une pluralité de noeuds feuilles, chacun d'eux étant couplé à une ligne de bits correspondante (BLij), où chaque noeud non feuille possède un ensemble de plusieurs branches de sélection dépendant de celui-ci, chaque branche s'étendant du noeud non feuille vers un noeud d'un niveau inférieur et comprenant au moins un des transistors (Mi, Mij, Pij),
où le moyen de sélection est adapté de façon à appliquer une tension de commande (Ycr(i), Ycs(j), Ycp(j)) à chaque transistor, les transistors correspondants dans les ensembles dépendant de noeuds situés au même niveau et recevant la même tension de commande, et
où dans chaque chemin le transistor le plus bas (Pij) est d'un premier type de conductivité et les transistors différents du transistor le plus bas sont d'un deuxième type de conductivité opposé au premier type.

3. Le système de décodage de colonnes (140,150) selon la Revendication 2, où pour le chemin sélectionné, le moyen de sélection est adapté de façon à polariser :
chaque transistor (Mi, Mij) différent du transistor le plus bas (Pij) vers une condition fermée de façon à appliquer la tension de polarisation au transistor le plus bas, et
le transistor le plus bas vers la condition fermée de façon à appliquer la tension de polarisation à la ligne de bits sélectionnée lorsque la ligne de bits sélectionnée doit être atteinte, ou vers la condition ouverte dans le cas contraire,
et où, pour chaque chemin non sélectionné le moyen de sélection est adapté de façon à polariser :
le transistor le plus bas vers la condition ouverte,
chaque transistor différent du transistor le plus bas correspondant à un transistor sur le chemin sélectionné vers la condition fermée, et
les transistors restants vers la condition de chute.

4. Le système de décodage de colonnes (140, 150) selon la Revendication 2 ou 3, où chaque transistor (Mi, Mij) du premier type est un transistor PMOS et chaque transistor (Pij) du deuxième type est un transistor NMOS.

5. Le système de décodage de colonnes (140,150) selon la Revendication 4, où :
chaque transistor (Mi, Mij, Pij) est inséré dans la branche correspondante par l'intermédiaire d'une borne de conduction supérieure et d'une borne de conduction inférieure, et reçoit la tension de commande correspondante sur une borne de commande, où chaque ligne de bits (BLij) est couplée à une borne fournissant une tension de masse par l'intermédiaire d'un ensemble correspondant de cellules de mémoire, et où :
pour chaque transistor NMOS (Mi, Mij), la tension de commande appliquée à la borne de commande est égale à ou plus élevée que la tension sur la borne de conduction supérieure plus la tension seuil de façon à amener le transistor NMOS vers la condition fermée,
pour chaque transistor PMOS (Pij), la tension de commande appliquée à la borne de commande est égale à ou inférieure à la tension sur la borne de conduction supérieure moins la tension seuil de façon à amener le transistor vers la condition fermée,
pour chaque transistor PMOS (Pij), la tension de commande appliquée à la borne de commande est plus élevée que la tension sur la borne de conduction supérieure moins la tension seuil de façon à amener le transistor vers la condition ouverte, et
pour chaque transistor NMOS (Mi, Mij), la tension de commande appliquée à la borne de commande est inférieure à la tension sur la borne de conduction supérieure plus la tension seuil mais égale à ou plus élevée que la tension de masse plus la tension seuil de façon à amener le transistor vers la condition de chute.

6. Le système de décodage de colonnes (140, 150) selon la Revendication 5, où la tension entre chaque paire de bornes de chaque transistor (Mi, Mij, Pij) est au plus égale à une tension d'alimentation du dispositif à mémoire, chaque transistor étant un transistor basse tension adapté de façon à supporter au plus la tension d'alimentation entre chaque paire de bornes de celui-ci.

7. Le système de décodage de colonnes (140, 150) selon l'une quelconque des Revendications 3 à 6, où, au cours d'une opération de programme, la tension de polarisation pour chaque paquet (PBL) dont la ligne de bits sélectionnée (BLij) doit être atteinte est une tension d'activation de programme.

8. Le système de décodage de colonnes (140, 150) selon l'une quelconque des Revendications 3 à 7, où, au cours d'une opération de programme, la tension de polarisation pour chaque paquet (PBL) dont la ligne de bits sélectionnée (BLij) ne doit pas être atteinte est inférieure à la tension de commande appliquée aux transistors les plus bas correspondants plus la tension seuil.

9. Un dispositif à mémoire non volatile (100) comprenant :
une pluralité de lignes de bits (BLij), les lignes de bits étant groupées en au moins un paquet,
un système de décodage de colonnes (140, 150) destiné à polariser de manière sélective les lignes de bits vers une tension de polarisation, et
un moyen (SAn, SAn') destiné à fournir la tension de polarisation,
**caractérisé en ce que :**
le système de décodage de colonnes est le système de décodage de colonnes selon l'une quelconque des Revendications précédentes.

10. Un procédé de décodage de colonnes destiné à polariser de manière sélective des lignes de bits d'un dispositif à mémoire non volatile, les lignes de bits étant groupées logiquement en au moins un paquet, où le procédé comprend les opérations suivantes :
la sélection d'un chemin correspondant à une ligne de bits sélectionnée parmi une pluralité de chemins de sélection, chacun d'eux étant destiné à appliquer une tension de polarisation à une ligne de bits correspondante, chaque chemin comprenant une pluralité de transistors de sélection reliés en série, chacun d'eux possédant une tension seuil, l'opération de sélection comprenant:
la polarisation d'au moins un transistor dans chaque chemin non sélectionné vers une condition ouverte de façon à faire flotter la ligne de bits non sélectionnée correspondante,
**caractérisé en ce que** l'opération de sélection comprend en outre :
la polarisation d'au moins un autre transistor dans chaque chemin non sélectionné vers une condition de chute de façon à introduire une chute de tension dans le chemin non sélectionné plus élevée que la tension seuil dudit un transistor en valeur absolue.
